# FASCICULE DE BREVET EUROPEEN

(11) **EP 2 683 669 B1**
(45) Date de publication et mention de la délivrance du brevet: **16.08.2017**
(21) Numéro de dépôt: 12712342.0
(22) Date de dépôt: 07.03.2012
(51) Int. Cl.: C03C 17/34, C03C 17/36, B23K 26/06, C23C 16/48, C23C 16/56, B23K 101/34, B23K 26/064, C03C 17/00, C23C 14/58

(54) **PROCEDE D'OBTENTION D'UN SUBSTRAT MUNI D'UN REVÊTEMENT**
VERFAHREN ZUR HERSTELLUNG EINES SUBSTRATS MIT EINER BESCHICHTUNG
METHOD FOR OBTAINING A SUBSTRATE PROVIDED WITH A COATING

(30) Priorité: 08.03.2011 FR 1151897
(43) Date de publication de la demande: 15.01.2014
(73) Titulaire: Saint-Gobain Glass France, 92400 Courbevoie (FR)
(72) Inventeur: BILAINE, Matthieu, F-75015 Paris (FR); YEH, Li-Ya, 52511 Geilenkirchen (DE)
(74) Mandataire: Saint-Gobain Recherche
(86) Numéro de dépôt international: PCT/FR2012/050476
(87) Numéro de publication internationale: WO 2012/120238

(56) Documents cités:
- WO-A1-2010/139908
- FR-A1- 2 911 130
- US-A1- 2004 241 922

## Description

L'invention se rapporte au traitement thermique de substrats munis de revêtements à l'aide d'un rayonnement laser.

On connaît des demandes WO 2008/096089, WO 2010/139908 ou encore WO 2010/142926 des méthodes de traitement thermique par rayonnement laser de revêtements déposés sur des substrats, notamment verriers. Les revêtements traités comprennent par exemple des couches minces d'argent, d'oxyde de titane ou encore d'oxydes transparents électroconducteurs (TCO). Le rayonnement laser permet de chauffer rapidement ces couches et d'améliorer leur conductivité électronique ou leur émissivité (pour les couches d'argent ou de TCO) ou encore leur activité photocatalytique (pour les couches d'oxyde de titane). Le chauffage rapide des couches ne chauffe pas substantiellement le substrat, qui n'est pas soumis à de fortes contraintes thermomécaniques, et peut être immédiatement manipulé et stocké, sans étape de refroidissement lent et contrôlé, comme c'est le cas pour des traitements de recuit classiques.

L'invention a pour but d'améliorer ce procédé afin de pouvoir utiliser des lasers moins puissants et donc moins coûteux pour une même vitesse de traitement, ou de pouvoir traiter les revêtements plus rapidement pour une même puissance de laser, ou encore de pouvoir, à même vitesse de traitement et même puissance de laser, améliorer encore les propriétés des revêtements traités.

A cet effet, un aspect de l'invention est un procédé d'obtention d'un substrat muni sur au moins une de ses faces d'un revêtement, comprenant une étape de dépôt dudit revêtement puis une étape de traitement thermique dudit revêtement à l'aide d'un rayonnement laser principal, ledit procédé étant caractérisé en ce qu'au moins une partie du rayonnement laser principal transmise au travers dudit substrat et/ou réfléchie par ledit revêtement est redirigée en direction dudit substrat pour former au moins un rayonnement laser secondaire, l'angle formé par le rayonnement principal et/ou le rayonnement secondaire et la normale au substrat étant non-nul. Les inventeurs ont pu mettre en évidence le fait que selon la nature des revêtements et la longueur d'onde du rayonnement laser, la majeure partie du rayonnement laser était transmise au travers du substrat ou réfléchie par le revêtement, et donc non utilisée pour le traitement du revêtement. En récupérant au moins une partie de ce rayonnement perdu et en le redirigeant vers le substrat, le traitement s'en trouve considérablement amélioré. Le choix d'utiliser la partie du rayonnement principal transmise au travers du substrat (mode « transmission ») ou la partie du rayonnement principal réfléchie par l'empilement (mode « réflexion »), ou éventuellement d'utiliser les deux, dépend de la nature de la couche et de la longueur d'onde du rayonnement laser. Typiquement, on choisira le mode « réflexion » si à la longueur d'onde du laser la réflexion par l'empilement est supérieure au carré de la transmission au travers du substrat.

Selon un premier mode de réalisation (« mode réflexion »), un seul rayonnement secondaire est formé, à partir de la partie du rayonnement laser principal réfléchie par le revêtement. C'est typiquement le cas lorsque le revêtement comprend au moins une couche d'argent et que la longueur d'onde du laser est comprise dans un domaine allant de 500 (notamment 700) à 2000 nm.

Selon un deuxième mode de réalisation (« mode transmission »), un seul rayonnement secondaire est formé, à partir de la partie du rayonnement laser principal transmise au travers du substrat.

Selon un troisième mode de réalisation (qui combine les modes « réflexion » et « transmission »), on forme deux rayonnements secondaires, l'un à partir de la partie réfléchie par l'empilement, l'autre à partir de la partie transmise au travers du substrat.

Le mode « réflexion » sera préférentiellement utilisé pour les revêtements fortement réfléchissants à la longueur d'onde du laser, typiquement dont la réflexion est d'au moins 20%.

Le revêtement peut être une couche mince individuelle, ou, le plus souvent, un empilement de couches minces, dont l'une au moins voit ses propriétés améliorées par le traitement thermique.

Dans le cadre du mode « réflexion », il est préférable que la réflexion du rayonnement principal par le revêtement soit due à la couche comprise dans le revêtement et dont les propriétés sont améliorées par le traitement thermique. Cela évite de disposer à dessein dans l'empilement des couches dont le seul but est de réfléchir le rayonnement principal, mais dont la présence serait finalement indésirable dans le produit fini. On préfère au contraire mettre à profit la réflexion « naturelle » de la couche à traiter. A titre d'exemple, lorsque l'empilement contient une couche réfléchissante (typiquement d'argent) dont on souhaite améliorer les propriétés de cristallisation, il est préférable de rediriger vers l'empilement la partie du rayonnement principal réfléchie par la couche réfléchissante elle-même, plutôt que par des couches disposées sous cette couche réfléchissante.

Le substrat est de préférence en verre ou en matière organique polymérique. Il est de préférence transparent, incolore (il s'agit alors d'un verre clair ou extra-clair) ou coloré, par exemple en bleu, gris, vert ou bronze. Le verre est de préférence de type silico-sodo-calcique, mais il peut également être en verre de type borosilicate ou alumino-borosilicate. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE). Le substrat présente avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, la couche à traiter peut aussi bien être déposée sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Le substrat de verre peut également être obtenu par laminage entre deux rouleaux, technique permettant en particulier d'imprimer des motifs à la surface du verre.

Le revêtement traité comprend de préférence une couche mince choisie parmi les couches d'argent, les couches d'oxyde de titane et les couches transparentes électroconductrices. Le revêtement est avantageusement un revêtement bas-émissif, notamment dont l'émissivité est d'au plus 20% ou 10%, par exemple comprenant au moins une couche d'argent. Ces revêtements présentent généralement de fortes réflexions aux longueurs d'ondes de laser comprises entre 700 et 2000 nm de sorte que l'efficacité du traitement est fortement améliorée grâce à l'invention.

De préférence, l'étape de traitement thermique ne met pas en oeuvre de fusion, même partielle, des couches présentes dans l'empilement. Le traitement thermique permet alors d'apporter une énergie suffisante pour favoriser la cristallisation de la couche mince par un mécanisme physico-chimique de croissance cristalline autour de germes déjà présents dans la couche, en restant en phase solide. Ce traitement ne met pas en oeuvre de mécanisme de cristallisation par refroidissement à partir d'un matériau fondu, d'une part car cela nécessiterait des températures extrêmement élevées, et d'autre part car cela serait susceptible de modifier les épaisseurs ou les indices de réfraction des couche, et donc leurs propriétés, en modifiant par exemple leur aspect optique. Les couches transparentes électroconductrices sont typiquement à base d'oxydes mixtes d'étain et d'indium (appelées « ITO »), à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé au fluor et/ou à l'antimoine. Ces différentes couches ont la particularité d'être des couches transparentes et néanmoins conductrices ou semiconductrices, et sont employées dans de nombreux systèmes où ces deux propriétés sont nécessaires : écrans à cristaux liquides (LCD), capteurs solaires ou photovoltaïques, dispositifs électrochromes ou électroluminescents (notamment LED, OLED)... Leur épaisseur, généralement pilotée par la résistance carrée désirée, est typiquement comprise entre 50 et 1000 nm, bornes comprises.

Pour les couches d'ITO, on utilisera de préférence le mode « transmission » (en réutilisant la partie du rayonnement principal transmise à travers le substrat), avec une longueur d'onde comprise dans un domaine allant de 400 à 1200 nm, notamment de 800 à 1000 nm. Dans le cas des couches d'oxyde de zinc ou d'étain, on utilisera avantageusement le mode « transmission », avec une longueur d'onde comprise dans un domaine allant de 400 nm à 12 micromètres, notamment de 1 à 12 micromètres.

Les couches minces à base d'argent métallique, mais aussi à base de molybdène ou de niobium métalliques, ont des propriétés de conduction électrique et de réflexion des rayonnements infrarouges, d'où leur utilisation dans des vitrages à contrôle solaire, notamment anti-solaires (visant à diminuer la quantité d'énergie solaire entrante) ou à faible émissivité (visant à diminuer la quantité d'énergie dissipée vers l'extérieur d'un bâtiment ou d'un véhicule). Leur épaisseur physique est typiquement comprise entre 4 et 20 nm (bornes comprises). Les empilements bas émissifs peuvent fréquemment comprendre plusieurs couches d'argent, typiquement 2 ou 3. La ou chaque couche d'argent est généralement entourée de couches diélectriques la protégeant de la corrosion et permettant d'ajuster l'aspect en réflexion du revêtement. Pour les couches d'argent dont l'épaisseur est d'au moins 11 nm, on utilisera de préférence le mode « réflexion »), avec une longueur d'onde allant de 400 (notamment 700) à 2000 nm, voire de 800 à 1200 nm (notamment 1000 nm). Dans le cas des couches d'argent dont l'épaisseur est inférieure à 11 nm et dans le cas des couches de niobium, on utilisera de préférence le mode « transmission », avec une longueur d'onde allant de 400 (notamment 700) à 2000 nm, voire de 800 à 1200 nm (notamment 1000 nm).

Les couches minces à base d'oxyde de titane ont la particularité d'être autonettoyantes, en facilitant la dégradation des composés organiques sous l'action de rayonnements ultraviolets et l'élimination des salissures minérales (poussières) sous l'action d'un ruissellement d'eau. Leur épaisseur physique est de préférence comprise entre 2 et 50 nm, notamment entre 5 et 20 nm, bornes comprises. Pour ce type de couches, on utilisera préférentiellement le mode « transmission », avec une longueur d'onde comprise dans un domaine allant de 400 nm à 12 micromètres, notamment de 500 à 1000 nm.

Les différentes couches citées présentent la particularité commune de voir certaines de leurs propriétés améliorées lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X), voire dans certains cas à favoriser une forme cristallographique particulière.

Dans le cas de l'oxyde de titane, il est connu que l'oxyde de titane cristallisé sous la forme anatase est bien plus efficace en terme de dégradation des composés organiques que l'oxyde de titane amorphe ou cristallisé sous la forme rutile ou brookite.

Il est également connu que les couches d'argent présentant un taux de cristallisation élevé et par conséquent une faible teneur résiduelle en argent amorphe présentent une émissivité et une résistivité plus basses que des couches d'argent majoritairement amorphes. La conductivité électrique et les propriétés de faible émissivité de ces couches sont ainsi améliorées.

De même, les couches transparentes conductrices précitées, notamment celles à base d'oxyde de zinc dopé ou les couches d'oxyde d'indium dopé à l'étain présentent une conductivité électrique d'autant plus forte que leur taux de cristallisation est élevé.

De préférence, lorsque le revêtement est conducteur, sa résistance carrée est diminuée d'au moins 10%, voire 15% ou même 20% par le traitement thermique. Il s'agit ici d'une diminution relative, par rapport à la valeur de la résistance carrée avant traitement.

L'utilisation d'un rayonnement laser présente l'avantage d'obtenir des températures généralement inférieures à 100°C, et même souvent inférieures à 50°C au niveau de la face opposée à la première face du substrat (c'est-à-dire au niveau de la face non revêtue). Cette caractéristique particulièrement avantageuse est due au fait que le coefficient d'échange thermique est très élevé, typiquement supérieur à 400 W/(m².s). La puissance surfacique du rayonnement laser au niveau de l'empilement à traiter est de préférence supérieure ou égale à 20 ou 30 kW/cm². Cette très forte densité d'énergie permet d'atteindre au niveau du revêtement la température souhaitée extrêmement rapidement (en général en un temps inférieur ou égal à 1 seconde) et par conséquent de limiter d'autant la durée du traitement, la chaleur générée n'ayant alors pas le temps de diffuser au sein du substrat. Ainsi, chaque point du revêtement est de préférence soumis au traitement selon l'invention (et notamment porté à une température supérieure ou égale à 300°C) pour une durée généralement inférieure ou égale à 1 seconde, voire 0,5 seconde. A l'inverse, les lampes infrarouge classiquement utilisées (sans dispositif de focalisation du rayonnement) ne permettant pas d'atteindre ces fortes puissances par unité de surface, le temps de traitement doit être plus long pour atteindre les températures désirées (souvent plusieurs secondes), et le substrat est alors nécessairement porté à des températures élevées par diffusion de la chaleur, ce même si la longueur d'ondes du rayonnement est adaptée pour n'être absorbée que par le revêtement et non par le substrat.

Grâce au très fort coefficient d'échange thermique associé au procédé selon l'invention, la partie du verre située à 0,5 mm du revêtement ne subit généralement pas de températures supérieures à 100°C. La température de la face du substrat opposée à la face traitée par le au moins un rayonnement laser n'excède de préférence pas 100°C, notamment 50°C et même 30°C pendant le traitement thermique.

Pour une simplicité de mise en oeuvre accrue, les lasers employés dans le cadre de l'invention peuvent être fibrés, ce qui signifie que le rayonnement laser est injecté dans une fibre optique puis délivré près de la surface à traiter par une tête de focalisation. Le laser peut également être à fibre, au sens où le milieu d'amplification est lui-même une fibre optique.

Le faisceau laser peut être ponctuel, auquel cas il est nécessaire de prévoir un système de déplacement du faisceau laser dans le plan du substrat.

De préférence toutefois, le rayonnement laser principal est issu d'au moins un faisceau laser formant une ligne (appelée « ligne laser » dans la suite du texte) qui irradie simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 1 m. Le profil de la ligne peut notamment être une courbe de Gauss ou un créneau.

La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit.

Afin de traiter toute la surface de la couche, on met de préférence en oeuvre un déplacement relatif entre d'une part le substrat et d'autre part la ou chaque ligne laser. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement.

Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Si le substrat en matière organique polymérique souple, le déplacement peut être réalisé à l'aide d'un système d'avance de films sous forme d'une succession de rouleaux.

Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Lorsque la ligne laser est en déplacement, il faut prévoir un système de déplacement du laser, situé au-dessus ou en dessous du substrat. La durée du traitement est régulée par la vitesse de déplacement de la ligne laser.

Toutes les positions relatives du substrat et du laser sont bien entendu possibles, du moment que la surface du substrat peut être convenablement irradiée. Le substrat sera le plus généralement disposé de manière horizontale, mais il peut aussi être disposé verticalement, ou selon toute inclinaison possible. Lorsque le substrat est disposé horizontalement, le laser est généralement disposé de manière à irradier la face supérieure du substrat. Le laser peut également irradier la face inférieure du substrat. Dans ce cas, il faut que le système de support du substrat, éventuellement le système de convoyage du substrat lorsque ce dernier est en mouvement, laisse passer le rayonnement dans la zone à irradier. C'est le cas par exemple lorsque l'on utilise des rouleaux de convoyage : les rouleaux étant disjoints, il est possible de disposer le laser dans une zone située entre deux rouleaux successifs.

Lorsque les deux faces du substrat sont à traiter, il est possible d'employer plusieurs lasers situés de part et d'autre du substrat, que ce dernier soit en position horizontale, verticale, ou selon toute inclinaison. Ces lasers peuvent être identiques ou différents, en particulier leurs longueurs d'onde peuvent être différentes, notamment adaptées à chacun des revêtements à traiter. A titre d'exemple, un premier revêtement (par exemple bas-émissif) situé sur une première face du substrat peut être traité par un premier rayonnement laser émettant par exemple dans le visible ou le proche infrarouge tandis qu'un second revêtement (par exemple un revêtement photocatalytique) situé sur la deuxième face dudit substrat peut être traité par un second rayonnement laser, émettant par exemple dans l'infrarouge lointain.

Le dispositif de rayonnement, par exemple le laser en ligne, peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif de rayonnement, par exemple le laser en ligne, est de préférence situé juste après l'installation de dépôt du revêtement, par exemple à la sortie de l'installation de dépôt. Le substrat revêtu peut ainsi être traité en ligne après le dépôt du revêtement, à la sortie de l'installation de dépôt et avant les dispositifs de contrôle optique, ou après les dispositifs de contrôle optique et avant les dispositifs d'empilage des substrats.

Le dispositif de rayonnement peut aussi être intégré à l'installation de dépôt. Par exemple, le laser peut être introduit dans une des chambres d'une installation de dépôt par pulvérisation cathodique, notamment dans une chambre où l'atmosphère est raréfiée, notamment sous une pression comprise entre 10⁻⁶ mbar et 10⁻² mbar. Le laser peut aussi être disposé en dehors de l'installation de dépôt, mais de manière à traiter un substrat situé à l'intérieur de ladite installation. Il suffit de prévoir à cet effet un hublot transparent à la longueur d'onde du rayonnement utilisé, au travers duquel le rayon laser viendrait traiter la couche. Il est ainsi possible de traiter une couche (par exemple une couche d'argent) avant le dépôt subséquent d'une autre couche dans la même installation.

Que le dispositif de rayonnement soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en oeuvre du traitement thermique selon l'invention est faite dans un lieu différent de celui où est réalisé le dépôt, par exemple dans un lieu où est réalisée la transformation du verre. Le dispositif de rayonnement peut donc être intégré à d'autres lignes que la ligne de dépôt de couches. Il peut par exemple être intégré à une ligne de fabrication de vitrages multiples (doubles ou triples vitrages notamment), ou à une ligne de fabrication de vitrages feuilletés. Dans ces différents cas, le traitement thermique selon l'invention est de préférence réalisé avant la réalisation du vitrage multiple ou feuilleté.

Le dépôt de l'empilement sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel.

L'empilement est de préférence déposé par pulvérisation cathodique, notamment assistée par champ magnétique (procédé magnétron).

Pour plus de simplicité, le traitement laser de la couche se fait de préférence sous air et/ou à pression atmosphérique. Il est toutefois possible de procéder au traitement thermique de la couche au sein même de l'enceinte de dépôt sous vide, par exemple avant un dépôt subséquent.

La longueur d'onde du rayonnement laser est de préférence comprise entre 500 et 2000 nm, notamment entre 700 et 1100 nm. Ce domaine de longueurs d'onde est particulièrement bien adapté au cas des couches d'argent. L'absorption du revêtement à la longueur d'onde du laser, définie de manière usuelle comme étant le complément à 100% de la réflexion et de la transmission, est avantageusement d'au moins 20%, notamment 30%. Au contraire, le verre (surtout le verre clair ou extra-clair) et la plupart des plastiques n'absorbent que peu dans ce domaine de longueur d'onde de sorte que le substrat n'est que peu chauffé par le rayonnement. On utilise de préférence des diodes laser, émettant par exemple à une longueur d'onde de l'ordre de 808 nm, 880 nm, 915 ou encore 940 nm ou 980 nm. Sous forme de systèmes de diodes, de très fortes puissances peuvent être obtenues, permettant d'atteindre des puissances surfaciques au niveau de l'empilement à traiter supérieures à 20 kW/cm², voire à 30 kW/cm².

Le rayonnement laser secondaire est de préférence formé en réfléchissant la partie du rayonnement laser principal transmise au travers du substrat et/ou réfléchie par le au moins un revêtement à l'aide d'au moins un miroir ou d'au moins un prisme, et éventuellement d'au moins une lentille.

De préférence, la formation du ou de chaque rayonnement laser secondaire met en oeuvre un montage optique ne comprenant que des éléments optiques choisis parmi les miroirs, les prismes et les lentilles, de préférence un montage constitué de deux miroirs et d'une lentille, ou d'un prisme et d'une lentille. De la sorte, le montage optique est totalement indépendant de la longueur d'onde du laser, contrairement au cas où le montage comprend des éléments tels que des séparateurs de faisceaux ou des lames à retard (lames quart d'onde, demi-onde...). Il est ainsi possible d'utiliser un même montage optique pour différents lasers.

Le rayonnement laser secondaire n'est de préférence pas polarisé. Le montage optique servant à former et rediriger le rayonnement laser secondaire est ainsi considérablement simplifié, en évitant des éléments tels que les séparateurs de faisceaux ou les lames à retard (lames quart d'onde, demi-onde...), qui ne peuvent fonctionner que pour une longueur d'onde bien spécifique, et entraînent des pertes de puissance.

L'angle formé par le rayonnement principal (et/ou le rayonnement secondaire) et la normale au substrat est non-nul, de préférence inférieur à 45°, notamment entre 8 et 13°, afin d'éviter tout endommagement du laser par la réflexion du rayonnement principal ou secondaire. Pour les mêmes raisons, il est préférable que l'angle formé par le rayonnement principal et la normale au substrat soit différent de l'angle formé par le rayonnement secondaire (en mode « transmission ») ou par la partie réfléchie du rayonnement secondaire (en mode « réflexion ») et la normale au substrat.

Pour améliorer l'efficacité du traitement, le rayonnement laser secondaire présente de préférence le même profil que le rayonnement laser principal.

Afin de renforcer l'efficacité du traitement, il est préférable que le rayonnement laser secondaire impacte le substrat au même endroit que le rayonnement laser principal. Par « même endroit », on entend que les deux rayonnements sont à une distance d'au plus 0,1 mm, voire 0,05 mm (distance mesurée sur la surface traitée). Pour optimiser l'efficacité du traitement, la profondeur de foyer du rayonnement laser secondaire est avantageusement la même que celle du rayonnement laser principal.

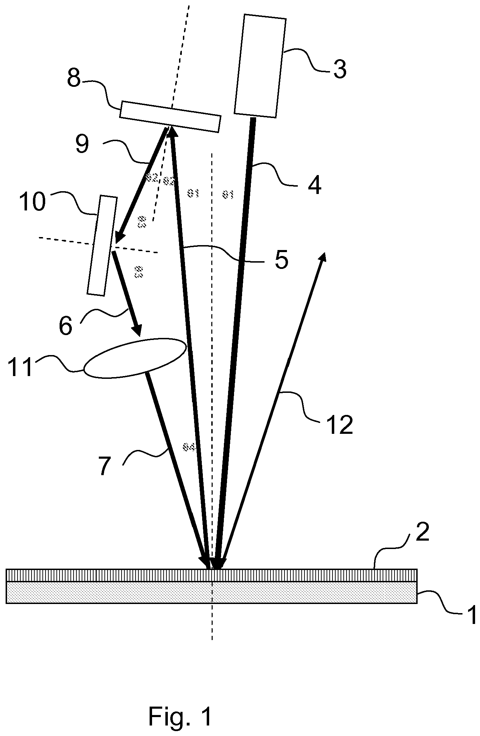

Différents montages optiques permettant de mettre en oeuvre le procédé selon l'invention sont illustrés par les Figures 1 à 3.

Dans un premier montage (non représenté), une partie du rayonnement principal est réfléchie par le revêtement, et un miroir unique est disposé de manière à réfléchir ce rayonnement vers le substrat. Préférentiellement, le rayonnement principal et le rayonnement secondaire impactent le revêtement au même endroit. Ce montage, très simple, ne comprend qu'un miroir. L'angle formé par le rayonnement principal et la normale au substrat est non-nul, de manière à éviter tout endommagement du laser par la réflexion du rayonnement principal. Cet angle est de préférence inférieur à 45°, typiquement compris entre 2 et 20°, notamment entre 8 et 13°. Ce montage est avantageusement utilisé pour des empilements hautement réfléchissants, tels que les empilements contenant au moins une couche d'argent.

Un deuxième montage, utile aussi, mais pas seulement, pour des revêtements fortement réfléchissants, est illustré en Figure 1. Il consiste à disposer un premier miroir 8 renvoyant le rayonnement principal réfléchi vers un second miroir 10, lequel forme par réflexion le rayonnement secondaire 6, 7. Une lentille permet éventuellement d'ajuster le rayonnement secondaire 7 et de le focaliser à l'endroit précis où le rayonnement principal 4 impacte le revêtement 2 (encore une fois avec une tolérance d'au plus 0,1 mm, voire 0,05 mm).

Plus précisément, un laser 3 émet un rayonnement principal 4 (typiquement un laser en ligne) vers le substrat 1 revêtu de son empilement 2, le rayonnement 4 formant avec la normale au substrat 1 un angle θ1.

Une partie de ce rayonnement principal 4 est réfléchie par l'empilement 2, sous la forme d'un rayonnement 5, qui forme également avec la normale au substrat le même angle θ1. L'angle θ1 est non-nul, notamment entre 5 et 15°, voire entre 8 et 13°, de manière à éviter que le rayonnement 5 vienne endommager le laser 3. La partie réfléchie 5 est alors à son tour réfléchie par un premier miroir 8 puis par un second miroir 10, de manière à former un rayonnement secondaire 6, 7, lequel est focalisé à l'aide d'une lentille 11 vers le revêtement 2. Les rayonnements 5 et 9 forment avec la normale au premier miroir 8 un angle θ2 non-nul, typiquement compris entre 5 et 15°, notamment entre 8 et 13°.

Ce montage est un peu plus complexe que le premier montage, mais est avantageux en ce que la partie 12 du rayonnement secondaire réfléchie par le revêtement 2 ne peut endommager le laser 3, du fait que l'angle θ4 entre le rayonnement secondaire 7 et la normale au substrat 2 est supérieur à l'angle θ1. L'angle θ4 est de préférence compris entre 10 et 20°, notamment entre 13 et 18°. Par un simple réglage de l'orientation des miroirs 8 et 10, et donc des angles θ2 et θ3, le rayonnement secondaire 7 peut impacter le revêtement 2 exactement au même endroit que le rayonnement principal 4.

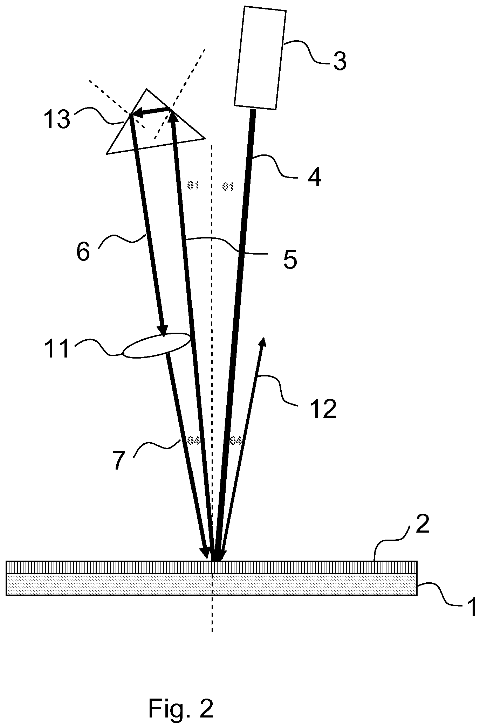

Selon une variante de ce deuxième montage, illustrée par la Figure 2, le premier et le deuxième miroir sont remplacés par un prisme 13, qui présente l'avantage d'une plus grande facilité de réglage.

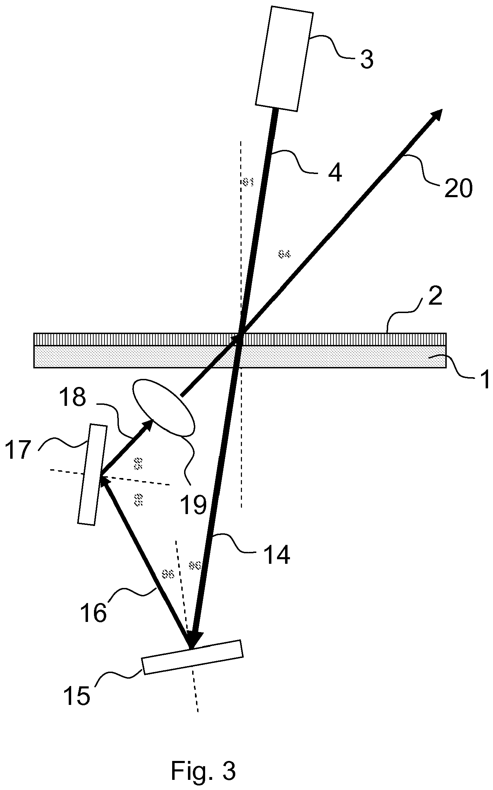

La Figure 3 illustre un troisième montage, mettant en oeuvre le mode « transmission » du procédé selon l'invention, utile pour le traitement de revêtements peu réfléchissants. Dans ce mode de réalisation, la partie 14 du rayonnement principal 4 transmise au travers du substrat 1 est réfléchie par un premier miroir 15, puis par un second miroir 17, pour former un rayonnement secondaire 18, qui après focalisation à l'aide d'une lentille 19, va impacter le revêtement 2 au même endroit que le rayonnement principal 4. L'utilisation de deux miroirs permet de choisir des angles θ5 et θ6 (entre le rayonnement 16 et les normales aux miroirs respectivement 15 et 17) non-nuls, dont il résulte un angle θ4 entre la partie transmise du rayonnement secondaire 18 et la normale au substrat 1 différent de l'angle θ1. Un tel montage permet encore une fois d'éviter d'endommager le laser 3 par réflexion directe du rayonnement transmis 14.

Selon une variante non-représentée, le substrat 1 peut être muni sur la face opposée à celle portant le revêtement 2, d'un revêtement 2', identique ou différent, lequel peut être également traité en même temps que le revêtement 2.

Afin d'améliorer encore les propriétés finales du revêtement, le substrat peut subir une étape de trempe après l'étape de traitement thermique selon l'invention. La trempe thermique sera généralement réalisée après découpe du verre aux dimensions finales voulues.

Lorsque le revêtement à traiter est un empilement bas-émissif, il comprend de préférence, à partir du substrat, un premier revêtement comprenant au moins une première couche diélectrique, au moins une couche d'argent, éventuellement une couche de sur-bloqueur et un deuxième revêtement comprenant au moins une deuxième couche diélectrique.

De préférence, l'épaisseur physique de la ou de chaque couche d'argent est comprise entre 6 et 20 nm.

La couche de sur-bloqueur est destinée à protéger la couche d'argent pendant le dépôt d'une couche ultérieure (par exemple si cette dernière est déposée sous atmosphère oxydante ou nitrurante) et pendant un éventuel traitement thermique du type trempe ou bombage.

La couche d'argent peut également être déposée sur et en contact avec une couche de sous-bloqueur. L'empilement peut donc comprendre une couche de sur-bloqueur et/ou une couche de sous-bloqueur encadrant la ou chaque couche d'argent.

Les couches de bloqueur (sous-bloqueur et/ou sur-bloqueur) sont généralement à base d'un métal choisi parmi le nickel, le chrome, le titane, le niobium, ou d'un alliage de ces différents métaux. On peut notamment citer les alliages nickel-titane (notamment ceux comprenant environ 50% en poids de chaque métal) ou les alliages nickel-chrome (notamment ceux comprenant 80% en poids de nickel et 20% en poids de chrome). La couche de sur-bloqueur peut encore être constituée de plusieurs couches superposées, par exemple, en s'éloignant du substrat, de titane puis d'un alliage de nickel (notamment un alliage nickel-chrome) ou l'inverse. Les différents métaux ou alliages cités peuvent également être partiellement oxydés, notamment présenter une sous-stoechiométrie en oxygène (par exemple TiOₓ ou NiCrOₓ).

Ces couches de bloqueur (sous-bloqueur et/ou sur-bloqueur) sont très fines, normalement d'une épaisseur inférieure à 1 nm, pour ne pas affecter la transmission lumineuse de l'empilement, et sont susceptibles d'être partiellement oxydées pendant le traitement thermique selon l'invention. D'une manière générale les couches de bloqueur sont des couches sacrificielles, susceptibles de capter l'oxygène provenant de l'atmosphère ou du substrat, évitant ainsi l'oxydation de la couche d'argent.

La première et/ou la deuxième couche diélectrique est typiquement en oxyde (notamment en oxyde d'étain), ou de préférence en nitrure, notamment en nitrure de silicium (en particulier pour la deuxième couche diélectrique, la plus éloignée du substrat). D'une manière générale, le nitrure de silicium peut être dopé, par exemple avec de l'aluminium ou du bore, afin de faciliter son dépôt par les techniques de pulvérisation cathodique. Le taux de dopage (correspondant au pourcentage atomique par rapport à la quantité de silicium) ne dépasse généralement pas 2%. Ces couches diélectriques ont pour fonction de protéger la couche d'argent des agressions chimiques ou mécaniques et influent également sur les propriétés optiques, notamment en réflexion, de l'empilement, grâce à des phénomènes interférentiels.

Le premier revêtement peut comprendre une couche diélectrique, ou plusieurs couches diélectriques, typiquement 2 à 4. Le deuxième revêtement peut comprendre une couche diélectrique, ou plusieurs couches diélectriques, typiquement 2 à 3. Ces couches diélectriques sont de préférence en un matériau choisi parmi le nitrure de silicium, les oxydes de titane, d'étain ou de zinc, ou l'un quelconque de leurs mélanges ou solutions solides, par exemple un oxyde d'étain et de zinc, ou un oxyde de titane et de zinc. Que ce soit dans le premier revêtement ou dans le deuxième revêtement, l'épaisseur physique de la couche diélectrique, ou l'épaisseur physique globale de l'ensemble des couches diélectriques, est de préférence comprise entre 15 et 60 nm, notamment entre 20 et 50 nm.

Le premier revêtement comprend de préférence, immédiatement sous la couche d'argent ou sous l'éventuelle couche de sous-bloqueur, une couche de mouillage dont la fonction est d'augmenter le mouillage et l'accrochage de la couche d'argent. L'oxyde de zinc, notamment dopé à l'aluminium, s'est révélé particulièrement avantageux à cet égard.

Le premier revêtement peut également contenir, directement sous la couche de mouillage, une couche de lissage, qui est un oxyde mixte partiellement voire totalement amorphe (donc de très faible rugosité), dont la fonction est de favoriser la croissance de la couche de mouillage selon une orientation cristallographique préférentielle, laquelle favorise la cristallisation de l'argent par des phénomènes d'épitaxie. La couche de lissage est de préférence composée d'un oxyde mixte d'au moins deux métaux choisis parmi Sn, Zn, In, Ga, Sb. Un oxyde préféré est l'oxyde d'étain et d'indium dopé à l'antimoine.

Dans le premier revêtement, la couche de mouillage ou l'éventuelle couche de lissage est de préférence déposée directement sur la première couche diélectrique. La première couche diélectrique est de préférence déposée directement sur le substrat. Pour adapter au mieux les propriétés optiques de l'empilement (notamment l'aspect en réflexion), la première couche diélectrique peut alternativement être déposée sur une autre couche en oxyde ou en nitrure, par exemple en oxyde de titane.

Au sein du deuxième revêtement, la deuxième couche diélectrique peut être déposée directement sur la couche d'argent, ou de préférence sur un sur-bloqueur, ou encore sur d'autres couches en oxyde ou en nitrure, destinées à adapter les propriétés optiques de l'empilement. Par exemple, une couche d'oxyde de zinc, notamment dopé à l'aluminium, ou encore une couche d'oxyde d'étain, peut être disposée entre un sur-bloqueur et la deuxième couche diélectrique, qui est de préférence en nitrure de silicium. L'oxyde de zinc, notamment dopé à l'aluminium, permet d'améliorer l'adhésion entre l'argent et les couches supérieures.

Ainsi, l'empilement traité selon l'invention comprend de préférence au moins une succession ZnO / Ag / ZnO. L'oxyde de zinc peut être dopé à l'aluminium. Une couche de sous-bloqueur peut être disposée entre la couche d'argent et la couche sous-jacente. Alternativement ou cumulativement, une couche de sur-bloqueur peut être disposée entre la couche d'argent et la couche sus-jacente.

Enfin, le deuxième revêtement peut être surmonté d'une surcouche, parfois appelée « overcoat » dans la technique. Dernière couche de l'empilement, donc en contact avec l'air ambiant, elle est destinée à protéger l'empilement contre toutes agressions mécaniques (rayures...) ou chimiques. Cette surcouche est généralement très fine pour ne pas perturber l'aspect en réflexion de l'empilement (son épaisseur est typiquement comprise entre 1 et 5 nm). Elle est de préférence à base d'oxyde de titane ou d'oxyde mixte d'étain et de zinc, notamment dopé à l'antimoine, déposé sous forme sous-stoechiométrique.

L'empilement peut comprendre une ou plusieurs couches d'argent, notamment deux ou trois couches d'argent. Lorsque plusieurs couches d'argent sont présentes, l'architecture générale présentée ci-avant peut être répétée. Dans ce cas, le deuxième revêtement relatif à une couche d'argent donnée (donc situé au-dessus de cette couche d'argent) coïncide généralement avec le premier revêtement relatif à la couche d'argent suivante.

Les substrats revêtus obtenus selon l'invention peuvent être utilisés dans des vitrages simples, multiples ou feuilletés, des miroirs, des revêtements muraux en verre. Si le revêtement est un empilement bas émissif, et dans le cas d'un vitrage multiple comportant au moins deux feuilles de verre séparées par une lame de gaz, il est préférable que l'empilement soit disposé sur la face en contact avec ladite lame de gaz, notamment en face 2 par rapport à l'extérieur (c'est-à-dire sur la face du substrat en contact avec l'extérieur du bâtiment qui est en opposée à la face tournée vers l'extérieur) ou en face 3 (c'est-à-dire sur la face du deuxième substrat en partant de l'extérieur du bâtiment tournée vers l'extérieur). Si le revêtement est une couche photocatalytique, il est de préférence disposé en face 1, donc en contact avec l'extérieur du bâtiment.

Les substrats revêtus obtenus selon l'invention peuvent aussi être utilisés dans des cellules ou vitrages photovoltaïques ou des panneaux solaires, le revêtement traité selon l'invention étant par exemple une électrode à base de ZnO : Al ou Ga dans des empilements à base de chalcopyrites (notamment du type CIS - CuInSe₂) ou à base de silicium amorphe et/ou polycristallin, ou encore à base de CdTe.

Les substrats revêtus obtenus selon l'invention peuvent encore être utilisés dans des écrans de visualisation du type LCD (Liquid Crystal Display), OLED (Organic Light Emitting Diodes) ou FED (Field Emission Display), le revêtement traité selon l'invention étant par exemple une couche électroconductrice en ITO. Ils peuvent encore être utilisés dans des vitrages électrochromes, la couche mince traitée selon l'invention étant par exemple une couche électroconductrice transparente tel qu'enseignée dans la demande FR-A-2 833 107.

L'invention est illustrée à l'aide des exemples de réalisation non limitatifs qui suivent.

### EXEMPLE 1

Sur un substrat en verre clair de 4 mm d'épaisseur commercialisé sous la dénomination SGG Planilux par la demanderesse, on dépose un empilement bas-émissif. L'empilement est déposé, de manière connue, sur une ligne de pulvérisation cathodique (procédé magnétron) dans laquelle le substrat vient défiler sous différentes cibles.

Le tableau 1 indique l'épaisseur physique des couches, exprimée en nm. La première ligne correspond à la couche la plus éloignée du substrat, en contact avec l'air libre.

**Tableau 1**

| | |
|---|---|
| ZnSnSbOₓ | 2 |
| Si₃N₄ : Al | 43 |
| ZnO :Al | 5 |
| Ti | 0,5 |
| Ag | 15 |
| ZnO :Al | 5 |
| TiO₂ | 11 |
| Si₃N₄ :Al | 14 |

Le tableau 2 ci-après récapitule les paramètres du dépôt employés pour les différentes couches.

**Tableau 2**

| Couche | Cible employée | Pression de dépôt | Gaz |
|---|---|---|---|
| Si₃N₄ | Si:Al à 92:8 % wt | 1,5.10⁻³ mbar | Ar / (Ar + N₂) à 45 % |
| TiO₂ | TiOₓ avec x de l'ordre de 1,9 | 1,5.10⁻³ mbar | Ar / (Ar + O₂) à 95 % |
| ZnSnSbOₓ | SnZn:Sb à 34:65:1 wt | 2.10⁻³ mbar | Ar / (Ar + O₂) à 58 % |
| ZnO :Al | Zn:Al à 98:2 % wt | 2.10⁻³ mbar | Ar / (Ar + O₂) à 52 % |
| Ti | Ti | 2.10⁻³ mbar | Ar |
| Ag | Ag | 2.10⁻³ mbar | Ar à 100 % |

Les échantillons sont traités à l'aide d'un laser en ligne émettant un rayonnement d'une longueur d'onde de 980 nm, en regard duquel le substrat revêtu vient défiler en translation. La puissance linéique est de 40 W/mm et l'épaisseur du faisceau est de 63 micromètres. La puissance surfacique est donc de 63 kW/cm². La vitesse de déplacement du substrat est de 5 m/min.

Le revêtement présente, à la longueur d'onde du laser, une réflexion de 65% et une transmission de 25%.

Selon une première configuration, on dispose en regard du revêtement un miroir permettant de réfléchir le rayonnement principal de sorte à former un rayonnement secondaire impactant le revêtement précisément au même endroit que le rayonnement principal. La perte de résistance carrée après traitement thermique est alors de 20 à 21% en relatif.

Selon une seconde configuration, on dispose en regard du revêtement deux miroirs et une lentille. La partie du rayonnement principal qui est réfléchie par le revêtement est à son tour réfléchie par le premier miroir, puis par un second miroir vers une lentille disposée de manière à refocaliser le rayonnement secondaire à l'endroit précis où le rayonnement principal impacte le revêtement. La perte de résistance carrée après traitement thermique est alors de 21 à 23% en relatif.

Sans réutilisation de la partie réfléchie du rayonnement principal, la perte de résistance carrée est de 18%.

La meilleure efficacité du traitement associée à ce gain en perte de résistance carrée permet d'accroître la vitesse de traitement d'environ 30% à perte égale.

### EXEMPLE 2

Sur un substrat en verre clair de 4 mm d'épaisseur commercialisé sous la dénomination SGG Planilux par la demanderesse, on dépose un empilement bas-émissif. L'empilement est déposé, de manière connue, sur une ligne de pulvérisation cathodique (procédé magnétron) dans laquelle le substrat vient défiler sous différentes cibles.

Le tableau 3 ci-après indique l'épaisseur physique des couches de l'empilement, exprimée en nm. La première ligne correspond à la couche la plus éloignée du substrat, en contact avec l'air libre.

**Tableau 3**

| | |
|---|---|
| ZnSnSbOₓ | 3 |
| Si₃N₄ :Al | 45 |
| ZnO :Al | 4 |
| TiOx | 2 |
| Ag | 6,7 |
| ZnO :Al | 5 |
| TiO₂ | 12 |
| Si₃N₄ :Al | 23 |

Les paramètres du dépôt employés pour les différentes couches sont ceux du tableau 2.

Les échantillons sont traités à l'aide d'un laser en ligne émettant un rayonnement d'une longueur d'onde de 980 nm, en regard duquel le substrat revêtu vient défiler en translation. La puissance linéique est de 40 W/mm et l'épaisseur du faisceau est de 63 micromètres. La puissance surfacique est donc de 63 kW/cm². La vitesse de déplacement du substrat est de 7,5 m/min.

Le revêtement présente, à la longueur d'onde du laser, une réflexion de 9% et une transmission de 73%.

On dispose en regard du revêtement un miroir permettant de réfléchir le rayonnement principal de sorte à former un rayonnement secondaire impactant le revêtement précisément au même endroit que le rayonnement principal. La perte de résistance carrée après traitement thermique est alors de 21,3% en relatif.

Sans réutilisation de la partie réfléchie du rayonnement principal, la perte de résistance carrée n'est que de 18%.

La meilleure efficacité du traitement associée à ce gain en perte de résistance carrée permet d'accroître la vitesse de traitement d'environ 30% à perte égale.

### EXEMPLE 3

On dépose sur un substrat en verre clair de 4 mm d'épaisseur commercialisé sous la dénomination SGG Planilux par la demanderesse une couche d'oxyde de zinc dopé à l'aluminium dont l'épaisseur est de 190 nm. L'empilement est déposé de manière connue, sur une ligne de pulvérisation cathodique (procédé magnétron).

Les échantillons sont traités à l'aide d'un laser CO₂ émettant sous forme d'une ligne laser un rayonnement principal dont la longueur d'onde est de 10,6 micromètres. La puissance du laser est de 300 W et la largeur de la ligne est de l'ordre de 0,5 mm.

A la longueur d'onde du laser, le revêtement présente une réflexion de 18,5% et une transmission de 74,4%.

Dans un essai comparatif, seul le rayonnement principal est utilisé pour traiter le revêtement. Pour une vitesse de déplacement du substrat sous le laser de 1,6 m/s, le gain en résistivité est de 57%, la valeur finale étant de 7,7.10⁻⁴ Ω.cm.

Dans un essai mettant en oeuvre le procédé selon l'invention, on dispose sous le substrat un montage optique constitué de 2 miroirs et d'une lentille, tel que représenté en Figure 3, afin de réfléchir vers le substrat le partie transmise du rayonnement principal (mode « transmission »). Le rayonnement secondaire ainsi formé impacte le substrat précisément au même endroit que le rayonnement principal.

L'utilisation du procédé selon l'invention permet d'atteindre le même gain de résistivité, mais avec une vitesse de défilement du substrat de 1,73 m/s, soit un gain de 8% de productivité.

### EXEMPLE 4

Sur un substrat en verre clair de 4 mm d'épaisseur commercialisé sous la dénomination SGG Planilux par la demanderesse, on dépose une couche de silice de 20 nm d'épaisseur puis une couche mince d'oxyde de titane de 10 nm d'épaisseur et enfin une couche mince de titane de 5 nm d'épaisseur. L'empilement est déposé, de manière connue, sur une ligne de pulvérisation cathodique (procédé magnétron) dans laquelle le substrat vient défiler sous différentes cibles (en l'espèce des cibles en silicium dopé à l'aluminium et en titane).

Entre la sortie de la ligne magnétron et le dispositif de stockage, un dispositif d'émission laser à base de diodes laser émettant à une longueur d'onde de 808 nm produit un rayonnement laser principal focalisé sur la couche de titane, selon une ligne correspondant à la largeur du substrat.

Dans un essai comparatif, seul le rayonnement principal est utilisé pour traiter le revêtement. Pour une vitesse de déplacement du substrat sous le laser de 4 m/minute, l'activité photocatalytique, mesurée selon le test décrit dans la demande WO2011039488 (par suivi de la dégradation de l'acide stéarique) est de 22.10⁻⁴.cm⁻¹.min⁻¹. La puissance linéique du laser est 37,5 W/mm.

Dans un essai mettant en oeuvre le procédé selon l'invention, on dispose sous le substrat un montage optique constitué d'un prisme et d'une lentille, tel que représenté en Figure 2, afin de réfléchir vers le substrat le partie réfléchie du rayonnement principal (mode « réflexion »). Le rayonnement secondaire ainsi formé impacte le substrat précisément au même endroit que le rayonnement principal.

L'utilisation du procédé selon l'invention permet d'aboutir au même niveau d'activité photocatalytique, à même puissance de laser, mais avec une vitesse de déplacement supérieure, de 4,2 m/min, soit un gain de productivité de 4%.

Inversement, pour une même vitesse de déplacement que pour l'essai comparatif (4 m/min), le même niveau d'activité photocatalytique a été obtenu, mais pour une puissance de laser moindre, de seulement 36,8 W/mm.

## Revendications

1. Procédé d'obtention d'un substrat (1) muni sur au moins une de ses faces d'un revêtement (2), comprenant une étape de dépôt dudit revêtement (2) puis une étape de traitement thermique dudit revêtement à l'aide d'un rayonnement laser principal (4), ledit procédé étant **caractérisé en ce qu'**au moins une partie (5, 14) du rayonnement laser principal (4) transmise au travers dudit substrat (1) et/ou réfléchie par ledit revêtement (2) est redirigée en direction dudit substrat pour former au moins un rayonnement laser secondaire (6, 7, 18), l'angle formé par le rayonnement principal (4) et/ou le rayonnement secondaire (6, 7, 18) et la normale au substrat (1) étant non-nul.

2. Procédé selon la revendication précédente , tel que le substrat (1) est en verre ou en matière organique polymérique.

3. Procédé selon l'une des revendications précédentes, tel que le revêtement (2) comprend au moins une couche mince choisie parmi les couches d'argent, les couches d'oxyde de titane et les couches transparentes électroconductrices.

4. Procédé selon l'une des revendications précédentes, tel que la température de la face du substrat (1) opposée à la face traitée par le au moins un rayonnement laser n'excède pas 100°C, notamment 50°C et même 30°C pendant le traitement thermique.

5. Procédé selon l'une des revendications précédentes, tel que le rayonnement laser principal (4) est issu d'au moins un faisceau laser formant une ligne qui irradie simultanément toute ou partie de la largeur du substrat (1).

6. Procédé selon la revendication précédente, dans lequel on met en oeuvre un déplacement relatif entre le substrat (1) et la ou chaque ligne laser, de sorte que la différence entre les vitesses respectives du substrat (1) et du laser soit supérieure ou égale à 4 mètres par minute, notamment 6 mètres par minute.

7. Procédé selon l'une des revendications précédentes, tel que la longueur d'onde du rayonnement laser (4) est comprise entre 500 et 2000 nm, notamment entre 700 et 1100 nm.

8. Procédé selon l'une des revendications précédentes, tel que le rayonnement laser secondaire (6, 7, 18) est formé en réfléchissant la partie (5, 14) du rayonnement laser principal (4) transmise au travers dudit substrat (1) et/ou réfléchie par ledit au moins un revêtement (2), à l'aide d'au moins un miroir (8, 10, 15, 17).

9. Procédé selon l'une des revendications précédentes, tel que le rayonnement laser secondaire (6, 7, 18) impacte le substrat (1) au même endroit que le rayonnement laser principal (4).

10. Procédé selon l'une des revendications précédentes, tel que le rayonnement laser secondaire (6, 7, 18) présente le même profil que le rayonnement laser principal (4).

11. Procédé selon l'une des revendications précédentes, tel que la profondeur de foyer du rayonnement laser secondaire (6, 7, 18) est la même que celle du rayonnement laser principal (4).

12. Procédé selon l'une des revendications précédentes, tel que l'angle formé par le rayonnement principal (4) et/ou le rayonnement secondaire (6, 7, 18) et la normale au substrat (1) est inférieur à 45°, notamment entre 8 et 13°.

13. Procédé selon l'une des revendications précédentes, tel que la formation du ou de chaque rayonnement laser secondaire (6, 7, 18) met en oeuvre un montage optique ne comprenant que des éléments optiques choisis parmi les miroirs (8, 10, 15, 17), les prismes (13) et les lentilles (11, 19).

14. Procédé selon la revendication précédente, tel que le montage optique est constitué de deux miroirs (8, 10, 15, 17) et d'une lentille (11, 19), ou d'un prisme (13) et d'une lentille (11).

15. Procédé selon l'une des revendications précédentes, tel que ledit au moins un revêtement (2) est déposé par pulvérisation cathodique assistée par champ magnétique.

## Patentansprüche

1. Verfahren zur Herstellung eines Substrats (1), das auf mindestens einer seiner Seiten mit einer Beschichtung (2) versehen ist, umfassend einen Schritt des Auftragens der Beschichtung (2) und dann einen Schritt der Wärmebehandlung der Beschichtung mittels eines Hauptlasers (4), wobei das Verfahren **dadurch gekennzeichnet ist, dass** mindestens ein Teil (5, 14) der Hauptlaserstrahlung (4), der durch das Substrat (1) übertragen und/oder durch die Beschichtung (2) reflektiert wird, in Richtung des Substrats umgelenkt wird, um mindestens eine Sekundärlaserstrahlung (6, 7, 18) zu bilden, wobei der Winkel, der durch die Hauptstrahlung (4) und/oder die Sekundärstrahlung (6, 7, 18) und die Normale des Substrats (1) gebildet wird, von Null verschieden ist.

2. Verfahren nach dem vorhergehenden Anspruch, wobei das Substrat (1) aus Glas oder aus organischem Polymermaterial ist.

3. Verfahren nach einem der vorhergehenden Ansprüche, wobei die Beschichtung (2) mindestens eine dünne Schicht umfasst, die aus den Silberschichten, den Titanoxidschichten und den elektrisch leitenden, transparenten Schichten ausgewählt ist.

4. Verfahren nach einem der vorhergehenden Ansprüche, wobei die Temperatur der Seite des Substrats (1), die der Seite gegenüberliegt, die durch die mindestens eine Laserstrahlung behandelt wird, 100 °C, inbesondere 50 °C, und sogar 30 °C während der Wärmebehandlung nicht überschreitet.

5. Verfahren nach einem der vorhergehenden Ansprüche, wobei die Hauptlaserstrahlung (4) aus mindestens einem Laserstrahl besteht, der eine Linie bildet, die gleichzeitig die gesamte Breite des Substrats (1) oder einen Teil davon bestrahlt.

6. Verfahren nach dem vorhergehenden Anspruch, wobei eine relative Verschiebung zwischen dem Substrat (1) und der oder jeder Laserline derart umgesetzt wird, dass der Unterschied zwischen den relativen Geschwindigkeiten des Substrats (1) und dem Laser größer als oder gleich 4 Meter pro Minute, insbesondere 6 Meter pro Minute, ist.

7. Verfahren nach einem der vorhergehenden Ansprüche, wobei die Wellenlänge der Laserstrahlung (4) zwischen 500 und 2.000 nm, insbesondere zwischen 700 und 1.100 nm beträgt.

8. Verfahren nach einem der vorhergehenden Ansprüche, wobei die Sekundärlaserstrahlung (6, 7, 18) gebildet wird, indem der Teil (5, 14) der Hauptlaserstrahlung (4), der durch das Substrat (1) übertragen wird und/oder durch die mindestens eine Beschichtung (2) reflektiert wird, mit Hilfe von mindestens einem Spiegel (8, 10, 15, 17) reflektiert wird.

9. Verfahren nach einem der vorhergehenden Ansprüche, wobei die Sekundärlaserstrahlung (6, 7, 18) an der gleichen Stelle wie die Hauptlaserstrahlung (4) auf das Substrat (1) eintrifft.

10. Verfahren nach einem der vorhergehenden Ansprüche, wobei die Sekundärlaserstrahlung (6, 7, 18) das gleiche Profil wie die Hauptlaserstrahlung (4) aufweist.

11. Verfahren nach einem der vorhergehenden Ansprüche, wobei die Tiefenschärfe der Sekundärlaserstrahlung (6, 7, 18) die gleiche ist wie jene der Hauptlaserstrahlung (4).

12. Verfahren nach einem der vorhergehenden Ansprüche, wobei der Winkel, der durch die Hauptstrahlung (4) und/oder die Sekundärstrahlung (6, 7, 18) und die Normale des Substrats (1) gebildet wird, niedriger als 45° ist, insbesondere zwischen 8 und 13° beträgt.

13. Verfahren nach einem der vorhergehenden Ansprüche, wobei das Bilden der oder jeder Sekundärlaserstrahlung (6, 7, 18) eine optische Anordnung umsetzt, die nur optische Elemente aufweist, die aus den Spiegeln (8, 10, 15, 17), den Prismen (13) und den Linsen (11, 19) ausgewählt werden.

14. Verfahren nach dem vorhergehenden Anspruch, wobei die optische Anordnung aus zwei Spiegeln (8, 10, 15, 17) und einer Linse (11, 19) oder aus einem Prisma (13) und einer Linse (11) gebildet wird.

15. Verfahren nach einem der vorhergehenden Ansprüche, wobei die mindestens eine Beschichtung (2) durch gepulste magnetfeldgestützte Kathodenzerstäubung aufgetragen wird.

## Claims

1. A process for obtaining a substrate (1) provided on at least one of its sides with a coating (2), comprising a step of depositing said coating (2) then a step of heat treatment of said coating using a main laser radiation (4), said process being **characterized in that** at least one portion (5, 14) of the main laser radiation (4) transmitted through said substrate (1) and/or reflected by said coating (2) is redirected in the direction of said substrate in order to form at least one secondary laser radiation (6, 7, 18), the angle formed by the main radiation (4) and/or the secondary radiation (6, 7, 18) and the normale to the substrate (1) being non-zero.

2. The process as claimed in one of the preceding claims, such that the substrate (1) is made of glass or of a polymeric organic material.

3. The process as claimed in either of the preceding claims, such that the coating (2) comprises at least one thin layer chosen from silver layers, titanium oxide layers and transparent electrically conductive layers.

4. The process as claimed in one of the preceding claims, such that the temperature of the side of the substrate (1) opposite the side treated by the at least one laser radiation does not exceed 100°C, in particular 50°C and even 30°C during the heat treatment.

5. The process as claimed in one of the preceding claims, such that the main laser radiation (4) results from at least one laser beam forming a line which simultaneously irradiates all or some of the width of the substrate (1).

6. The process as claimed in the preceding claim, wherein a relative movement between the substrate (1) and the or each laser line is carried out so that the difference between the respective speeds of the substrate (1) and of the laser is greater than or equal to 4 meters per minute, in particular 6 meters per minute.

7. The process as claimed in one of the preceding claims, such that the wavelength of the laser radiation (4) is between 500 and 2000 nm, in particular between 700 and 1100 nm.

8. The process as claimed in one of the preceding claims, such that the secondary laser radiation (6, 7, 18) is formed by reflecting the portion (5, 14) of the main laser radiation (4) transmitted through said substrate (1) and/or reflected by said at least one coating (2), using at least one mirrors (8, 10, 15, 17).

9. The process as claimed in one of the preceding claims, such that the secondary laser radiation (6, 7, 18) impacts the substrate (1) at the same location as the main laser radiation (4).

10. The process as claimed in one of the preceding claims, such that the secondary laser radiation (6, 7, 18) has the same profile as the main laser radiation (4).

11. The process as claimed in one of the preceding claims, such that the depth of focus of the secondary laser radiation (6, 7, 18) is the same as that of the main laser radiation (4).

12. The process as claimed in one of the preceding claims, such that the angle formed by the main radiation (4) and/or the secondary radiation (6, 7, 18) and the normale to the substrate (1) is less than 45°C, in particular between 8° and 13°.

13. The process as claimed in one of the preceding claims, such that the formation of the or each secondary laser radiation (6, 7, 18) uses an optical assembly that comprises only optical elements chosen from mirrors (8, 10, 15, 17), prisms (13) and lenses (11, 19).

14. The process as claimed in the preceding claim, such that the optical assembly consists of two mirrors (8, 10, 15, 17) and of one lens (11, 19), or of one prism (13) and of one lens (11).

15. The process as claimed in one of the preceding claims, such that said at least one coating (2) is deposited by magnetron sputtering.
